# FASCICULE DE BREVET EUROPEEN

(11) **EP 2 151 054 B1**
(45) Date de publication et mention de la délivrance du brevet: **20.07.2016**
(21) Numéro de dépôt: 08760249.6
(22) Date de dépôt: 30.05.2008
(51) Int. Cl.: H03K 17/96, G06F 3/01

(54) **DISPOSITIF DE COMMANDE TACTILE À RETOUR HAPTIQUE**
BERÜHRUNGSSTEUEREINRICHTUNG MIT HAPTISCHER RÜCKMELDUNG
HAPTIC FEEDBACK TACTILE CONTROL DEVICE

(30) Priorité: 01.06.2007 FR 0703904
(43) Date de publication de la demande: 10.02.2010
(73) Titulaire: DAV, 94000 Creteil (FR)
(72) Inventeur: LAURENT, Patrice, F-74106 Annemasse (FR); DROUIN, Xavier, F-74106 Annemasse (FR)
(74) Mandataire: Delplanque, Arnaud
(86) Numéro de dépôt international: PCT/EP2008/056659
(87) Numéro de publication internationale: WO 2008/145716

(56) Documents cités:
- US-A1- 2002 101 838
- US-A1- 2004 069 605
- US-B1- 6 340 936

## Description

La présente invention est relative à un dispositif de commande tactile à retour haptique, en particulier pour véhicule automobile.

Plus précisément, un tel dispositif de commande trouve une application avantageuse pour les commandes se trouvant au niveau de la console entre les deux sièges avant d'un véhicule automobile pour par exemple commander des fonctions de climatisation, d'un système audio, d'un système de téléphonie ou encore d'un système de navigation.

L'invention peut aussi être appliquée dans une région du véhicule appelée le dôme ou le plafonnier qui se situe au niveau de l'emplacement habituel du rétroviseur intérieur, pour par exemple commander des lumières intérieures, un verrouillage central, un toit ouvrant, les feux de détresse ou les lumières d'ambiance à l'intérieur du véhicule.

Ce module peut également servir pour les commandes de lève-vitres, des commandes de positionnement des rétroviseurs extérieurs motorisés, des commandes multifonction sur volant ou encore des commandes de déplacement de sièges motorisés.

Dans le domaine automobile, les commandes de divers organes électriques sont réalisées classiquement par des commutateurs / interrupteurs. Toutefois, au vu du nombre croissant d'organes électriques à commander, des dispositifs de commande multifonctions sont de plus en plus utilisés du fait des avantages ergonomiques qui en résultent. En effet, à partir d'un seul bouton de commande, réalisé par exemple sous forme d'un joystick, associé à un écran d'afficlzage, on peut naviguer dans des menus déroulants pour commander par exemple la climatisation, le système audio ou encore le système de navigation.

Pour augmenter le confort ergonomique, l'utilisation d'une technologie à capteur tactile, seul ou en complément de tels boutons multifonctions, peut être considérée comme un développement intéressant.

En effet, les capteurs tactiles, en particulier pour le domaine automobile, ont fait des progrès importants. Une technologie utilisant des résistances sensibles à la pression (également connu sous le nom capteur FSR pour « Force Sensing Resistor ») devance de plus en plus d'autres technologies équivalentes, comme par exemple des technologies capacitives ou encore optiques grâce à sa facilité de mise en oeuvre et sa robustesse.

De tels capteurs sont par exemple connus sous le nom « tablette digitalisante » (dénomination anglaise "Digitizer pad") et on cite comme art antérieur les documents suivants : US 4,810,992, US 5,008,497, FR 2683649 ou encore EP 0 541 102.

Ces capteurs comprennent des couches semi-conductrices souples prises en sandwich entre par exemple une couche conductrice et une couche résistive. En exerçant une pression sur la couche FSR, sa résistance ohmique diminue permettant ainsi, par application d'une tension électrique adaptée, de mesurer la pression appliquée et / ou la localisation de l'endroit où la pression est exercée.

Selon une conception différente de la technologie FSR, le capteur tactile comprend deux feuilles souples de support espacées l'une de l'autre par des entretoises élastiques et portant sur des faces mutuellement en regard des éléments permettant de réaliser un contact électrique lors de la compression du capteur (voir par exemple EP 1 429 355 et EP 1 429 356).

D'autres technologies de capteurs tactiles comprennent par exemple des capteurs matriciels de contact, ou des capteurs du type capacitif.

Dans l'implémentation de ces technologies tactiles, en particulier avec des surfaces lisses de contact, on doit prendre en compte que ces commandes sont souvent réalisées en aveugle, lors de la conduite du véhicule.

Pour ne pas dévier l'attention du conducteur de la route, il est donc important que celui-ci ait un retour de sa commande tactile effectuée en aveugle. Ceci peut par exemple être réalisé à l'aide d'un retour haptique.

A cet effet, la surface tactile du capteur est reliée mécaniquement à un ou plusieurs vibreurs qui sont déclenchés à la détection d'une commande tactile. Ainsi, le conducteur sent au niveau du bout de son doigt de commande affleurant la surface tactile une vibration témoignant que sa commande a bien été prise en compte.

Une difficulté des dispositifs de commande tactiles à retour haptique connus réside dans l'encombrement des vibreurs qui sont généralement directement montés au contact de la surface tactile pour procurer une sensation de vibration suffisante.

Pour pallier à cet inconvénient, il a été proposé d'agencer les vibreurs au niveau de la structure de support de la surface tactile.

US 6,340,936 décrit un exemple d'agencement de vibreur au niveau de la structure de support de la surface tactile.

Or, il a été constaté que le résultat n'était pas toujours satisfaisant au niveau de la perception du retour haptique. De plus, pour certains cas, une augmentation importante de la puissance de vibration, et donc une augmentation de la puissance électrique consommée par les vibreurs, a été nécessaire.

La présente invention vise à proposer un dispositif de commande tactile à retour haptique qui permette un agencement déporté du ou des vibreurs tout en maintenant la puissance de vibration des vibreurs à un niveau faible acceptable.

A cet effet, l'invention a pour objet un dispositif de commande tactile à retour haptique comprenant une surface tactile permettant de détecter le toucher par exemple d'un doigt de commande d'un utilisateur, et au moins un vibreur couplé à ladite surface tactile pour pouvoir appliquer une vibration à ladite surface en retour d'une détection d'un toucher, caractérisé en ce qu'il comprend en outre un guide creux de vibrations mécaniques de forme allongée qui est couplé à au moins un vibreur et dont une extrémité est reliée mécaniquement à la surface tactile au niveau d'une ouverture ménagée dans la surface tactile.

D'autres caractéristiques et avantages de l'invention ressortiront de la description suivante, donnée à titre d'exemple, sans caractère limitatif, en regard des dessins annexés sur lesquels :
- la figure 1 est une vue en perspective et en éclaté d'un dispositif selon l'invention, et
- la figure 2 est une vue en coupe transversale du dispositif de la figure 1 à l'état assemblé.

L'invention est relative à un dispositif de commande électrique et plus particulièrement à un dispositif de commande tactile à retour haptique, c'est-à-dire que la commande est opérée par un appui par exemple d'un doigt d'un utilisateur et que ce dernier ressent un retour haptique, par exemple une vibration, au niveau du doigt de commande signalant la prise en compte de sa commande tactile. Par vibration, on entend de façon large tout déplacement de va et vient, en particulier des micro-déplacements avec des amplitudes inférieurs à 0,2mm.

Un tel dispositif peut être utilisé avantageusement dans le domaine automobile pour toute commande du type « surfacique », c'est-à-dire une commande pour laquelle on promène par exemple un doigt sur une surface de commande ou pour laquelle la commande se réalise par un simple appui sur une surface de commande.

Comme exemple, on peut citer les commandes de sièges motorisés, des commandes de lève-vitres, des commandes des miroirs extérieurs motorisés, des commandes au niveau du plafonnier comme les commandes d'éclairage intérieur, les commandes d'ouverture d'un toit ouvrant, des commandes de climatisation, des commandes multifonctions de téléphonie, de navigation ou encore du système audio etc.

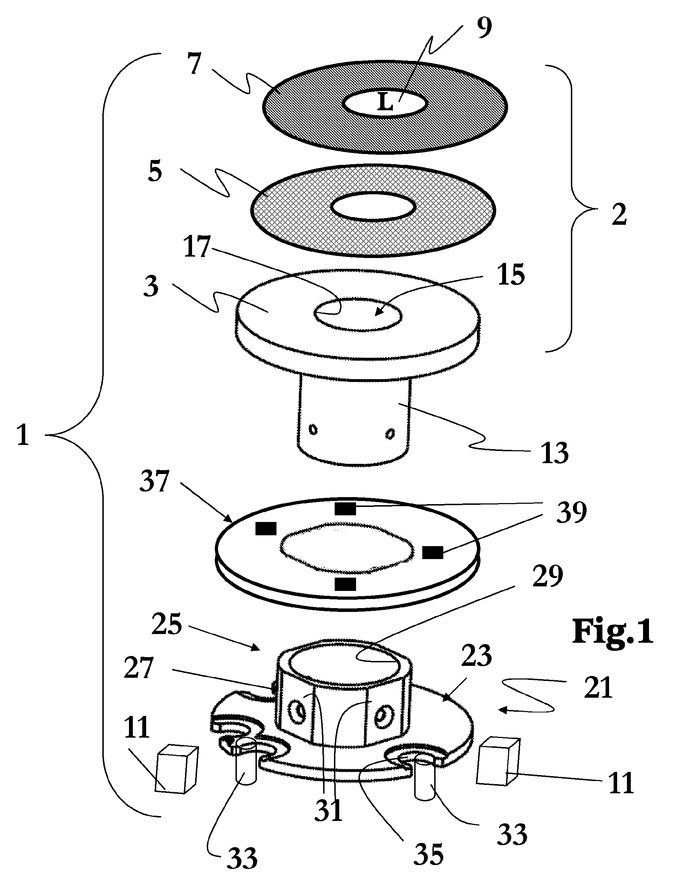

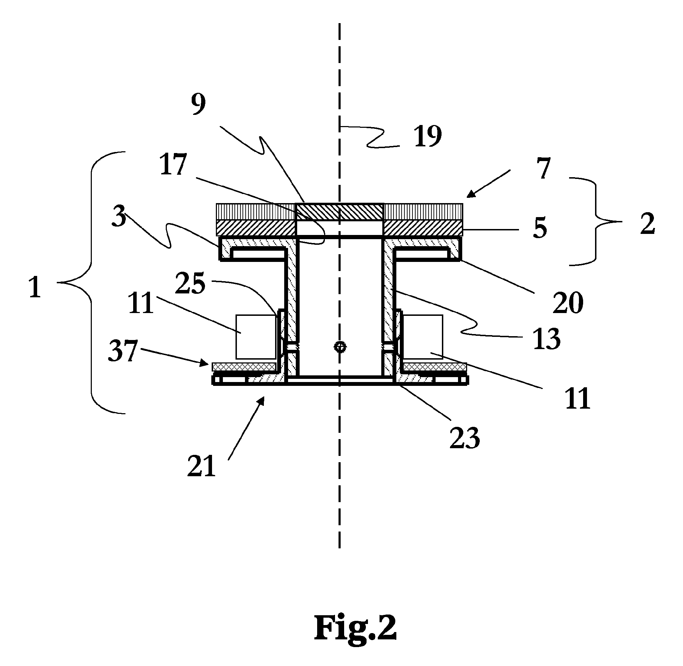

En référence aux figures 1 et 2, on va décrire en détail la structure et le fonctionnement du dispositif de commande tactile à retour haptique selon l'invention.

Le dispositif 1 de commande tactile à retour haptique comprend une surface tactile 2 présentant une surface de support 3 et un capteur tactile 5 disposé sur cette surface de support 3. Le capteur tactile 5 peut être un capteur capacitif, résistif ou optique, mais de préférence, il s'agit d'un capteur tactile sensible à la pression et plus particulièrement d'un capteur FSR, par exemple utilisant des résistances sensibles à la pression.

Cette surface tactile 2 permet de détecter le toucher par exemple d'un doigt de commande d'un utilisateur. La surface de support 3 ainsi que le capteur tactile 5 présentent une forme de rondelle, c'est-à-dire une bande de forme annulaire, définissant ainsi une piste de commande circulaire. Bien entendu, on peut imaginer aussi d'autres formes pour la surface tactile 2, par exemple des formes ovales, rectangulaires, carrées (plus généralement polygonales).

Au dessus du capteur 5 est placé un recouvrement 7, par exemple une peau en matière élastique tel que de la silicone ou une plaque déformable tel qu'une plaque en matière plastique, par exemple du type « black panel » (c'est-à-dire une plaque qui a un aspect uniforme, par exemple noir en absence d'un rétroéclairage et qui affiche par exemple des pictogrammes lors d'un rétroéclairage), sur lequel on peut par exemple faire figurer des pictogrammes de commande pour l'utilisateur. Ce recouvrement 7 possède également une forme de rondelle avec une ouverture centrale.

L'ouverture centrale du recouvrement est fermée à l'aide d'une pièce de décoration sous forme d'un bouchon 9 portant par exemple un logo « L ».

Ainsi, en promenant son doigt sur la surface de recouvrement 7, le capteur tactile 5 détecte la position du doigt de commande, voir le sens de déplacement du doigt et/ou encore la pression d'appui ce qui est transmis par un signal représentatif à une unité de traitement (non-représentée). Cette unité de traitement comporte par exemple des filtres pour traiter des signaux électriques entrant ainsi qu'un microcontrôleur pour déterminer à partir des signaux entrant la position d'appui, les sens de déplacement et/ ou la pression d'appui. En fonction de la position, du déplacement et/ou de la pression détectés, l'unité de traitement transmet une commande à un organe ou élément électrique et/ ou électronique, par exemple pour une commande dans un menu déroulant d'un ordinateur de bord d'un véhicule automobile.

Ainsi, on peut par exemple prévoir qu'un déplacement sur la surface tactile 2 dans le sens horaire va augmenter le volume d'un autoradio d'un véhicule et un déplacement dans le sens inverse une diminution du volume. La distinction de diverses pressions d'appui et positions (par exemple appui faible / appui fort) permet par exemple de distinguer la sélection d'une fonction dans un menu déroulant d'un ordinateur de bord et de validation de la fonction ainsi sélectionnée.

On obtient ainsi par un capteur tactile une commande du type « roue tournante » ou « scroll wheel » en anglais, le cas échéant avec une fonction de validation d'une fonction.

Afin de permettre à un utilisateur de se rendre compte en aveugle des commandes qu'il applique au niveau du dispositif 1, ce dernier est équipé d'au moins un, voir plusieurs vibreurs (dans le cas présent, il y a deux vibreurs).

Pour acheminer les vibrations mécaniques des vibreurs 11 vers la surface de commande sur laquelle l'utilisateur promène son doigt, le dispositif comprend un guide 13 creux de vibrations mécaniques de forme allongée qui est couplé à au moins un vibreur 11 (directement ou indirectement) et dont une extrémité 15 du guide 13 est reliée mécaniquement à la surface de support 3 au niveau d'une ouverture 17, de préférence centrale, ménagée dans la surface de support 3.

Ainsi, les vibreurs peuvent être agencés déportés de la surface tactile 2 tout en réalisant un retour haptique efficace au niveau de la surface tactile 2 avec une puissance de vibration contenue, voir faible.

De préférence le guide 13 et la surface de support 3 sont réalisés en une seule pièce, par exemple en matière plastique.

Sur les figures, le guide présente une forme générale d'un tube de section circulaire. Une réalisation avec une section ovale, voir rectangulaire ou carré peut également être envisagé.

En effet, si on souhaite réaliser un dispositif de commande tactile de forme carrée, il s'est avéré judicieux de réaliser l'ouverture 17 en forme carrée ainsi que le tube avec une section carré.

Pour une transmission optimisée des vibrations mécaniques l'axe longitudinale 19 (voir figure 2) du guide 13 de vibrations mécaniques est perpendiculaire à la surface de support 3.

Avantageusement l'épaisseur de paroi du guide 13 de vibrations mécaniques est identique à l'épaisseur de la surface de support 3 de manière que les vibrations ne subissent pas d'altérations substantielles comme par exemple un changement de fréquence ou un changement d'amplitude. Cette épaisseur constante assure une continuité pour la propagation des vibrations, c'est-à-dire des ondes mécaniques de surface.

Ainsi que l'on peut voir sur les figures (en particulier sur la figure 2 en coupe transversale), la pièce formant d'une part le guide 13 de vibrations et d'autre part la surface de support 3, est une pièce de révolution. Ainsi, les vibrations cheminent le long de la paroi du guide 13 vers le haut (vu sur la figure 2) pour ensuite s'étendre radialement le long de la surface de support 3.

On a constaté que cette disposition est particulièrement avantageuse du fait que les vibrations mécaniques s'étendent et se développent radialement vers l'extérieur. Ainsi, on évite les interférences pouvant diminuer l'amplitude des vibrations. On assure ainsi une propagation cohérente des ondes de surface comparable à la propagation des ondes de surface qui se développent lorsque l'on jette par exemple un caillou dans un plan d'eau.

Comme on le voit sur les figures, la périphérie de la surface de support 3 se termine par un bord annulaire 20 ayant une portion perpendiculaire par rapport à la surface 3. Ce bord 20 ne sert non seulement à la fixation du recouvrement 9, mais il permet aussi de diminuer les réflexions des ondes mécaniques une fois que celles-ci parviennent depuis le centre à la périphérie de la surface de support 3, contribuant ainsi également à réduire toute diminution de l'amplitude des vibrations, cette fois par des ondes réfléchies.

Selon un mode de réalisation non représenté ledit au moins un vibreur est fixé directement contre une paroi du guide de vibrations mécaniques.

Toutefois, pour pouvoir ajouter plus de fonctionnalités à ce dispositif de commande, il est préférable que le dispositif comprend en outre une embase 21 présentant un socle de fixation 23 surmonté d'une cheminée 25 dont la paroi externe 27 porte ledit au moins un vibreur 11 et dont la paroi interne 29 est en contact avec la paroi externe du guide 13 de vibrations mécaniques.

Afin de faciliter la fixation, la paroi externe 27 de la cheminée 25 présente pour chaque vibreur un méplat 31 de fixation.

Comme cela est représenté sur la figure 1, le dispositif de commande tactile à retour haptique comprend deux vibreurs 11 disposés l'un de l'autre à 90° par rapport à l'axe longitudinale 19 du guide 13 de vibrations mécaniques. Une disposition à 180° est bien entendu aussi envisageable. Dans tous les cas avec plusieurs vibreurs 11, il faut prendre soin de ne pas générer au niveau du guide 13 des ondes mécaniques en opposition de phase qui auraient tendance à s'annuler, mais plutôt des vibrations mécaniques en phase pour obtenir une amplification, voir un effet de résonance.

Pour ne pas générer un bruit et des vibrations indésirables au niveau de l'habitacle, le dispositif de commande tactile à retour haptique comporte des éléments élastiques 33 de fixation montés dans des décrochements 35 du socle 23 pour empêcher la propagation des vibrations mécaniques vers une structure de support telle que la planche de bord.

Le dispositif de commande tactile comporte en outre une carte 37 à circuit imprimé portée par le socle 23. Cette carte peut par exemple porter l'unité de traitement des signaux du capteur tactile 5.

On prévoit en outre de réaliser d'une part la surface de support 3 du capteur tactile et le guide 13 d'ondes mécaniques en une matière transparente ou translucide, et d'autre part de réaliser le capteur tactile 5 ainsi que le recouvrement 7 (ce dernier au moins partiellement, au niveau des pictogrammes) de manière à laisser passer de la lumière. En outre, le dispositif comporte sur l'embase 21, de préférence au niveau du circuit imprimé 37, des sources lumineuses 39 (par exemple des diodes électroluminescentes) permettant un rétro-éclairage de la surface tactile.

Comme on le voir sur la figure 2, l'assemblage de la surface de support 3 du capteur tactile 5, du guide 13 de vibrations mécaniques et de l'embase 21 avec son socle 23 et sa cheminée 25 présente un profil en H en coupe transversale qui est facilement intégrable, par exemple au niveau d'une planche de bord avec un encombrement réduit.

## Revendications

1. Dispositif de commande tactile à retour haptique comprenant une surface tactile (2) permettant de détecter le toucher par exemple d'un doigt de commande d'un utilisateur, et au moins un vibreur (11) couplé à ladite surface tactile (2) pour pouvoir appliquer une vibration à ladite surface en retour d'une détection d'un toucher, **caractérisé en ce qu'**il comprend en outre un guide (13) creux de vibrations mécaniques de forme allongée qui est couplé à au moins un vibreur (11) et dont une extrémité (15) est reliée mécaniquement à la surface tactile au niveau d'une ouverture ménagée (17) dans la surface tactile (2).

2. Dispositif de commande tactile à retour haptique selon la revendication 1, **caractérisé en ce que** le guide (13) de vibrations mécaniques présente une forme générale d'un tube.

3. Dispositif de commande tactile à retour haptique selon la revendication 2, **caractérisé en ce que** le tube (13) possède une section ovale ou circulaire.

4. Dispositif de commande tactile à retour haptique selon la revendication 2, **caractérisé en ce que** le tube (13) possède une section rectangulaire ou carrée.

5. Dispositif de commande tactile à retour haptique selon l'une quelconque des revendications 1 à 4, **caractérisé en ce que** l'axe longitudinale (19) du guide de vibrations mécaniques (13) est perpendiculaire à la surface tactile (2).

6. Dispositif de commande tactile à retour haptique selon l'une quelconque des revendications 1 à 5, dans lequel la surface tactile (2) comprend une surface de support (3) et un capteur tactile (5) disposé sur cette surface de support, **caractérisé en ce que** le guide de vibrations mécaniques (13) et la surface de support (3) sont réalisés d'une seule pièce.

7. Dispositif de commande tactile à retour haptique selon la revendication 6, **caractérisé en ce que** l'épaisseur de paroi du guide de vibrations mécaniques (13) est identique à l'épaisseur de la surface de support (3).

8. Dispositif de commande tactile à retour haptique selon la revendication 7, **caractérisé en ce que** la pièce formant d'une part le guide de vibrations mécaniques (13) et d'autre part la surface de support (3), est une pièce de révolution.

9. Dispositif de commande tactile à retour haptique selon l'une quelconque des revendications 1 à 8, **caractérisé en ce que** ledit au moins un vibreur (11) est fixé directement contre une paroi du guide de vibrations mécaniques.

10. Dispositif de commande tactile à retour haptique selon l'une quelconque des revendications 1 à 8, **caractérisé en ce qu'**il comprend en outre une embase (21) présentant un socle de fixation (23) surmonté d'une cheminée (25) dont la paroi externe (27) porte ledit au moins un vibreur (11) et dont la paroi interne (29) est en contact avec la paroi externe du guide de vibrations mécaniques (13).

11. Dispositif de commande tactile à retour haptique selon l'une quelconque des revendications 1 à 10, **caractérisé en ce que** la paroi externe (27) de la cheminée présente pour chaque vibreur (11) un méplat de fixation (31).

12. Dispositif de commande tactile à retour haptique selon l'une quelconque des revendications 1 à 11, **caractérisé en ce qu'**il comporte deux vibreurs (11) disposés l'un de l'autre à 90° ou à 180° par rapport à l'axe longitudinale (19) du guide de vibrations mécaniques (13).

13. Dispositif de commande tactile à retour haptique selon l'une quelconque des revendications 1 à 12, **caractérisé en ce qu'**il comporte des éléments élastiques de fixation (33) montés dans des décrochements (35) du socle (23) pour empêcher la propagation des vibrations mécaniques vers une structure de support.

14. Dispositif de commande tactile à retour haptique selon l'une quelconque des revendications 10 à 13, **caractérisé en ce qu'**il comporte une carte à circuit imprimé (37) portée par le socle de fixation (23).

15. Dispositif de commande tactile à retour haptique selon la revendication 14, **caractérisé en ce que** la surface de support (3) et le guide de vibrations mécaniques (13) sont réalisés en une matière transparente ou translucide, **en ce que** le capteur tactile (5) est réalisé de manière à laisser passer de la lumière et **en ce que** l'embase (21) porte des sources lumineuses (39) permettant un rétro-éclairage de la surface tactile (2).

16. Dispositif de commande tactile à retour haptique selon l'une quelconque des revendications 10 à 15, **caractérisé en ce que** l'assemblage de la surface de support (2), du guide de vibrations mécaniques (13) et de l'embase (21) avec son socle (23) et sa cheminée (25) présente un profil en H en coupe transversale.

## Patentansprüche

1. Vorrichtung zur Berührungssteuerung mit haptischer Rückmeldung, die eine berührungsempfindliche Fläche (2), welche die Berührung durch zum Beispiel einem Steuerfinger eines Benutzers zu erfassen ermöglicht, und mindestens einen Vibrator (11) enthält, der mit der berührungsempfindlichen Fläche (2) gekoppelt ist, um als Reaktion auf die Erfassung einer Berührung eine Schwingung auf die Fläche anwenden zu können, **dadurch gekennzeichnet, dass** sie außerdem einen hohlen länglichen Leiter (13) mechanischer Schwingungen enthält, der mit mindestens einem Vibrator (11) gekoppelt ist und von dem ein Ende (15) mechanisch mit der berührungsempfindlichen Fläche im Bereich einer Öffnung (17) gekoppelt ist, die in der berührungsempfindlichen Fläche (2) ausgespart ist.

2. Vorrichtung zur Berührungssteuerung mit haptischer Rückmeldung nach Anspruch 1, **dadurch gekennzeichnet, dass** der Leiter (13) mechanischer Schwingungen die allgemeine Form eines Rohrs hat.

3. Vorrichtung zur Berührungssteuerung mit haptischer Rückmeldung nach Anspruch 2, **dadurch gekennzeichnet, dass** das Rohr (13) einen ovalen oder kreisförmigen Querschnitt besitzt.

4. Vorrichtung zur Berührungssteuerung mit haptischer Rückmeldung nach Anspruch 2, **dadurch gekennzeichnet, dass** das Rohr (13) einen rechtwinkligen oder quadratischen Querschnitt besitzt.

5. Vorrichtung zur Berührungssteuerung mit haptischer Rückmeldung nach einem der Ansprüche 1 bis 4, **dadurch gekennzeichnet, dass** die Längsachse (19) des Leiters mechanischer Schwingungen (13) lotrecht zur berührungsempfindlichen Fläche (2) ist.

6. Vorrichtung zur Berührungssteuerung mit haptischer Rückmeldung nach einem der Ansprüche 1 bis 5, wobei die berührungsempfindliche Fläche (2) eine Trägerfläche (3) und einen Berührungssensor (5) enthält, der auf dieser Trägerfläche angeordnet ist, **dadurch gekennzeichnet, dass** der Leiter mechanischer Schwingungen (13) und die Trägerfläche (3) aus einem Stück hergestellt sind.

7. Vorrichtung zur Berührungssteuerung mit haptischer Rückmeldung nach Anspruch 6, **dadurch gekennzeichnet, dass** die Wanddicke des Leiters mechanischer Schwingungen (13) gleich der Dicke der Trägerfläche (3) ist.

8. Vorrichtung zur Berührungssteuerung mit haptischer Rückmeldung nach Anspruch 7, **dadurch gekennzeichnet, dass** das einerseits den Leiter mechanischer Schwingungen (13) und andererseits die Trägerfläche (3) bildende Bauteil ein drehsymmetrisches Bauteil ist.

9. Vorrichtung zur Berührungssteuerung mit haptischer Rückmeldung nach einem der Ansprüche 1 bis 8, **dadurch gekennzeichnet, dass** der mindestens eine Vibrator (11) direkt gegen eine Wand des Leiters mechanischer Schwingungen befestigt ist.

10. Vorrichtung zur Berührungssteuerung mit haptischer Rückmeldung nach einem der Ansprüche 1 bis 8, **dadurch gekennzeichnet, dass** sie außerdem eine Grundplatte (21) enthält, die einen Befestigungssockel (23) aufweist, über dem ein Schacht (25) angeordnet ist, dessen Außenwand (27) den mindestens einen Vibrator (11) trägt und dessen Innenwand (29) mit der Außenwand des Leiters mechanischer Schwingungen (13) in Kontakt ist.

11. Vorrichtung zur Berührungssteuerung mit haptischer Rückmeldung nach einem der Ansprüche 1 bis 10, **dadurch gekennzeichnet, dass** die Außenwand (27) des Schachts eine Befestigungsabflachung (31) für jeden Vibrator (11) aufweist.

12. Vorrichtung zur Berührungssteuerung mit haptischer Rückmeldung nach einem der Ansprüche 1 bis 11, **dadurch gekennzeichnet, dass** sie zwei Vibratoren (11) aufweist, die zueinander in einem Winkel von 90° oder 180° bezüglich der Längsachse (19) des Leiters mechanischer Schwingungen (13) angeordnet sind.

13. Vorrichtung zur Berührungssteuerung mit haptischer Rückmeldung nach einem der Ansprüche 1 bis 12, **dadurch gekennzeichnet, dass** sie elastische Befestigungselemente (33) aufweist, die in Ausbuchtungen (35) des Sockels (23) montiert sind, um die Ausbreitung der mechanischen Schwingungen zu einer Trägerstruktur zu verhindern.

14. Vorrichtung zur Berührungssteuerung mit haptischer Rückmeldung nach einem der Ansprüche 10 bis 13, **dadurch gekennzeichnet, dass** sie eine vom Befestigungssockel (23) getragenen Leiterplatte (37) aufweist.

15. Vorrichtung zur Berührungssteuerung mit haptischer Rückmeldung nach Anspruch 14, **dadurch gekennzeichnet, dass** die Trägerfläche (3) und der Leiter mechanischer Schwingungen (13) aus einem durchsichtigen oder durchscheinenden Material hergestellt sind, dass der Berührungssensor (5) so hergestellt ist, dass er Licht durchlässt, und dass die Grundplatte (21) Lichtquellen (39) trägt, die eine Hintergrundbeleuchtung der berührungsempfindlichen Fläche (2) erlauben.

16. Vorrichtung zur Berührungssteuerung mit haptischer Rückmeldung nach einem der Ansprüche 10 bis 15, **dadurch gekennzeichnet, dass** der Zusammenbau der Trägerfläche (2), des Leiters mechanischer Schwingungen (13) und der Grundplatte (21) mit ihrem Sockel (23) und ihrem Schacht (25) im Querschnitt ein H-förmiges Profil aufweist.

## Claims

1. Haptic feedback tactile control device comprising a tactile surface (2) making it possible to detect the touch, for example, of a user's control finger, and at least one vibrator (11) coupled to the said tactile surface (2) in order to be able to apply a vibration to the said surface as a response to a detection of a touch, **characterized in that** it furthermore comprises a hollow mechanical vibrations guide (13) of elongated shape which is coupled to at least one vibrator (11) and of which one end (15) is mechanically connected to the tactile surface at an opening (17) formed in the tactile surface (2).

2. Haptic feedback tactile control device according to Claim 1, **characterized in that** the mechanical vibrations guide (13) has a generally tubular shape.

3. Haptic feedback tactile control device according to Claim 2, **characterized in that** the tube (13) has an oval or circular cross-section.

4. Haptic feedback tactile control device according to Claim 2, **characterized in that** the tube (13) has a rectangular or square cross-section.

5. Haptic feedback tactile control device according to any one of Claims 1 to 4, **characterized in that** the longitudinal axis (19) of the mechanical vibrations guide (13) is perpendicular to the tactile surface (2).

6. Haptic feedback tactile control device according to any one of Claims 1 to 5, wherein the tactile surface (2) comprises a support surface (3) and a tactile sensor (5) disposed on this support surface, **characterized in that** the mechanical vibrations guide (13) and the support surface (3) are made in one piece.

7. Haptic feedback tactile control device according to Claim 6, **characterized in that** the wall thickness of the mechanical vibrations guide (13) is identical to the thickness of the support surface (3).

8. Haptic feedback tactile control device according to Claim 7, **characterized in that** the part forming on the one hand the mechanical vibrations guide (13) and on the other hand the support surface (3), is a solid of revolution.

9. Haptic feedback tactile control device according to any one of Claims 1 to 8, **characterized in that** the said at least one vibrator (11) is fixed directly against a wall of the mechanical vibrations guide.

10. Haptic feedback tactile control device according to any one of Claims 1 to 8, **characterized in that** it furthermore comprises a base (21) having a fixing flange (23), surmounted by a chimney (25) whose outside surface (27) carries the said at least one vibrator (11) and whose inside surface (29) is in contact with the outside surface of the mechanical vibrations guide (13).

11. Haptic feedback tactile control device according to any one of Claims 1 to 10, **characterized in that** the outside surface (27) of the chimney has one mounting flat (31) for each vibrator (11).

12. Haptic feedback tactile control device according to any one of Claims 1 to 11, **characterized in that** it comprises two vibrators (11) disposed at 90° or at 180° to each other with respect to the longitudinal axis (19) of the mechanical vibrations guide (13).

13. Haptic feedback tactile control device according to any one of Claims 1 to 12, **characterized in that** it comprises elastic fixing elements (33) fitted in notches (35) of the flange (23) in order to prevent the propagation of mechanical vibrations to a support structure.

14. Haptic feedback tactile control device according to any one of Claims 10 to 13, **characterized in that** it comprises a printed circuit board (37) supported by the fixing flange (23).

15. Haptic feedback tactile control device according to Claim 14, **characterized in that** the support surface (3) and the mechanical vibrations guide (13) are made from a transparent or translucent material, **in that** the tactile sensor (5) is produced in such a way as to allow light to pass through and **in that** the base (21) carries light sources (39) allowing a backlighting of the tactile surface (2).

16. Haptic feedback tactile control device according to any one of Claims 10 to 15, **characterized in that** the assembly of the support surface (2) of the mechanical vibrations guide (13) and of the base (21) with its flange (23) and its chimney (25) has an H-shaped cross-sectional profile.
